# FASCICULE DE BREVET EUROPEEN

(11) **EP 3 084 842 B1**
(45) Date de publication et mention de la délivrance du brevet: **21.08.2019**
(21) Numéro de dépôt: 14818955.8
(22) Date de dépôt: 17.12.2014
(51) Int. Cl.: H01L 31/068, H01L 31/042

(54) **STRUCTURE PHOTOVOLTAIQUE**
FOTOVOLTAIKSTRUKTUR
PHOTOVOLTAIC STRUCTURE

(30) Priorité: 18.12.2013 FR 1362894
(43) Date de publication de la demande: 26.10.2016
(73) Titulaire: Commissariat à l'Énergie Atomique et aux Énergies Alternatives, 75015 Paris (FR)
(72) Inventeur: GERRITSEN, Eric, 38190 Bernin (FR); MANGEANT, Christophe, 73170 Yenne (FR)
(74) Mandataire: Regimbeau
(86) Numéro de dépôt international: PCT/EP2014/078298
(87) Numéro de publication internationale: WO 2015/091689

(56) Documents cités:
- EP-A1- 0 371 000
- EP-A1- 2 597 031
- EP-A1- 2 624 307
- DE-A1- 2 726 629

## Description

### DOMAINE DE L'INVENTION

La présente invention concerne une structure photovoltaïque comprenant une première paroi et une seconde paroi définissant entre elles un volume intérieur, une pluralité de modules photovoltaïques étant agencés sur la première paroi.

### ARRIERE PLAN DE L'INVENTION

Le domaine aéronautique a mis à profit l'allègement des matériaux permettant la fabrication de modules photovoltaïques pour concevoir des objets volants (par exemple des ballons dirigeables lenticulaires) équipés de tels modules pour assurer l'alimentation électrique dudit objet.

L'objet volant comprend ainsi une structure porteuse comprenant deux parois définissant entre elles un volume fermé contenant un gaz léger : une paroi supérieure convexe (extrados) destinée à être exposée au rayonnement solaire et une paroi inférieure de courbure opposée à celle de la paroi supérieure (intrados).

Des modules photovoltaïques sont agencés sur la paroi supérieure au moyen d'un système d'accrochage qui permet leur démontage.

Grâce aux matériaux employés, ces modules photovoltaïques sont très légers : ils sont typiquement constitués d'un empilement d'un support en matériau composite, d'un encapsulant, de cellules photovoltaïques, d'un encapsulant, et d'une face avant protectrice.

Compte tenu de la symétrie de révolution de l'objet, les modules photovoltaïques sont répartis selon différents secteurs angulaires, les modules d'un même secteur étant reliés en série et chaque secteur étant relié à un convertisseur de courant qui est lui-même relié à des batteries électriques constituant la source d'énergie de l'objet volant.

Cependant, les performances de ce dispositif en termes de production d'énergie sont pénalisées par des variations d'éclairement (par exemple, l'obscurcissement d'un ou plusieurs secteurs, partiellement ou en totalité, par un nuage, ou encore un éclairement non homogène des différents secteurs en fonction de l'orientation de l'objet par rapport au soleil).

Cette problématique n'est d'ailleurs pas propre aux objets volants mais peut s'appliquer aussi, par exemple, à des objets flottant sur la mer ou l'océan et portant des modules photovoltaïques, ou encore à des structures légères (chapiteaux démontables, gonflables) destinées aux événements (sportifs ou autres).

Le document EP 2 597 031 divulgue une structure selon le préambule de la revendication 1. Les documents DE2726629 et EP 0 371 000 décrivent d'autres structures munies de modules photovoltaïques.

### BREVE DESCRIPTION DE L'INVENTION

Un but de l'invention est donc de concevoir une structure photovoltaïque comprenant une pluralité de modules photovoltaïques et présentant des performances améliorées en termes de production d'énergie et ce, malgré des conditions d'éclairement inhomogène des différents modules.

Conformément à l'invention, il est proposé une structure photovoltaïque comprenant une première paroi et une seconde paroi définissant entre elles un volume intérieur,
la première paroi étant au moins partiellement transparente au rayonnement solaire et comprenant une face extérieure destinée à être exposée au rayonnement solaire et une face intérieure,
la deuxième paroi comprenant une face intérieure en regard de la face intérieure de la première paroi, ladite face intérieure de la deuxième paroi étant au moins partiellement réfléchissante vis-à-vis du rayonnement solaire, la première paroi formant une partie d'une enveloppe fermée et la deuxième paroi étant agencée à l'intérieur de ladite enveloppe,
une pluralité de modules photovoltaïques comprenant chacun une pluralité de cellules photovoltaïques bifaciales, lesdits modules étant agencés sur la face extérieure de la première paroi, chaque cellule bifaciale comprenant une face extérieure destinée à être exposée au rayonnement solaire incident et une face intérieure en regard de la face extérieure de la première paroi,
de sorte que lorsque la structure est exposée au rayonnement solaire, une première portion du rayonnement incident est transmise vers la face extérieure desdites cellules photovoltaïques bifaciales, une deuxième portion dudit rayonnement incident est transmise à travers une partie de la première paroi et se réfléchit au moins partiellement sur la face intérieure de la deuxième paroi, ladite portion réfléchie étant transmise à travers la première paroi vers la face intérieure des cellules photovoltaïques bifaciales.

Par « bifaciale » on entend une cellule photovoltaïque dont chacune des faces principales est photoactive. De telles cellules peuvent être obtenues en ne métallisant que localement la face arrière d'une cellule conventionnelle, par exemple sous forme d'une grille ou sous toute autre forme. Pour la mise en oeuvre de l'invention, on peut considérer une cellule bifaciale dont au moins 50% de la surface de chaque face est adaptée pour transmettre un rayonnement incident. Les cellules bifaciales actuellement disponibles commercialement ont un ratio de performance entre le rendement obtenu par la face arrière et le rendement obtenu par la face avant entre 85 et 95%.

Par « au moins partiellement transparente », on entend que la première paroi permet la transmission d'au moins une partie de l'intensité du rayonnement solaire. Typiquement, entre 40% et 90% de l'intensité du rayonnement solaire passe au travers de la première paroi.

Par « agencée à l'intérieur de l'enveloppe » on entend que la deuxième paroi est distincte des parois de l'enveloppe.

De manière avantageuse, l'enveloppe est étanche aux gaz et aux liquides.

De manière avantageuse, les modules photovoltaïques sont agencés de manière non jointive sur la première paroi, une portion du rayonnement incident étant transmise au travers d'une partie de la première paroi située entre deux modules photovoltaïques non jointifs.

Selon un mode de réalisation, la deuxième paroi est plane.

Selon un mode de réalisation, la deuxième paroi présente une courbure ajustée en fonction de la courbure de la première paroi et de la répartition des modules photovoltaïques sur la première paroi pour optimiser la réflexion du rayonnement incident transmis au travers d'une région de la première paroi vers la face intérieure des cellules desdits modules situés dans la région opposée de ladite première paroi.

Selon une forme d'exécution particulière, la structure comprend un dispositif d'actionnement de la deuxième paroi, adapté pour ajuster la courbure de ladite deuxième paroi en fonction de la position de la structure par rapport au soleil.

De manière avantageuse, la structure présente au moins un plan ou un axe de symétrie.

Selon un mode de réalisation, la première paroi présente une forme convexe de révolution et les modules photovoltaïques sont répartis sur ladite première paroi selon une pluralité de secteurs angulaires, les modules photovoltaïques d'un même secteur angulaire étant reliés en série.

Une portion sommitale de la première paroi peut être dépourvue de modules photovoltaïques.

De manière particulièrement avantageuse, tous les modules photovoltaïques agencés sur la première paroi sont identiques.

De préférence, les modules photovoltaïques sont agencés de manière réversible sur la première paroi.

Le matériau de la première paroi peut comprendre un tissu de fibres de verre ; la deuxième paroi peut être en polytéréphtalate d'éthylène (PET) métallisé sur sa face intérieure.

Un autre objet de l'invention concerne un ballon dirigeable lenticulaire comprenant une structure photovoltaïque telle que décrite ci-dessus, l'enveloppe de ladite structure étant remplie d'un gaz porteur.

Un autre objet de l'invention concerne un dôme destiné en particulier à flotter à la surface d'une mer ou d'un océan, comprenant une structure photovoltaïque telle que décrite ci-dessus.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue en coupe d'une structure photovoltaïque conforme à un mode de réalisation de l'invention,
- la figure 2 est une vue en coupe de la structure de la figure 1 au niveau d'un module photovoltaïque,
- la figure 3 est une vue en perspective d'une structure photovoltaïque selon une forme d'exécution de l'invention,
- la figure 4 est un schéma en perspective d'un moyen de fixation d'un module à la paroi de la structure photovoltaïque,
- les figures 5A à 5C illustrent la répartition de l'irradiance du rayonnement solaire sur la surface de la première paroi de la structure à trois instants (8h30, 14h00, 17h00) d'une journée,
- la figure 6 est une vue en coupe d'une structure photovoltaïque selon un autre mode de réalisation de l'invention,
- la figure 7 est une vue en coupe d'une autre structure photovoltaïque,
- la figure 8 est un schéma de principe d'une structure photovoltaïque selon un autre mode de réalisation de l'invention.

### DESCRIPTION DETAILLEE DE MODES DE REALISATION DE L'INVENTION

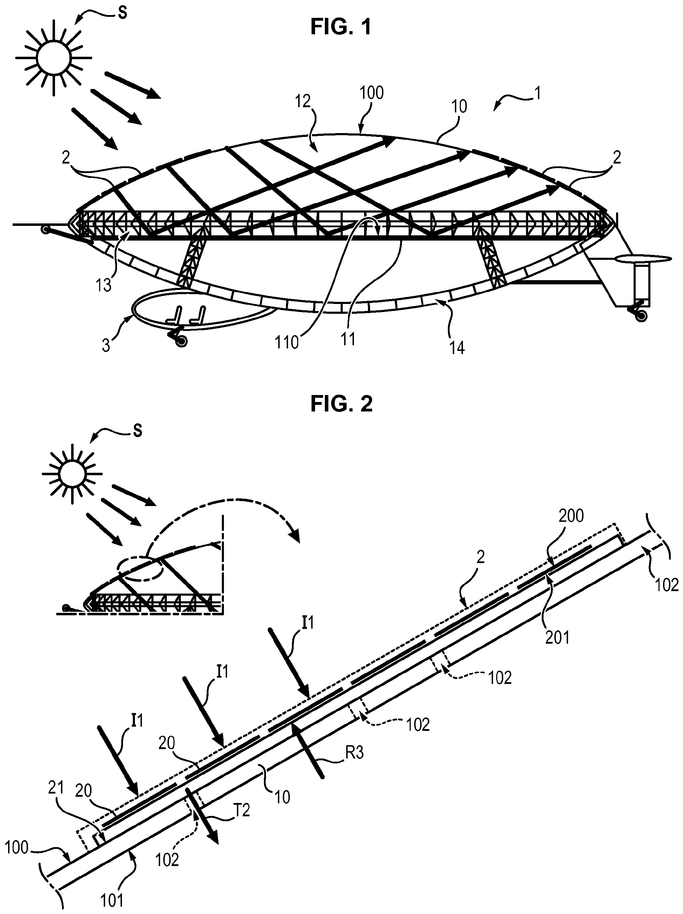

La figure 1 est une vue en coupe d'un mode de réalisation dans lequel la structure photovoltaïque est un ballon dirigeable.

Un tel objet volant trouve des applications avantageuses dans des missions d'observation, des opérations de cartographie, ou encore du transport de charges vers des zones peu accessibles, par exemple en ville ou en montagne.

L'invention n'est cependant pas limitée à ce type de structure mais peut trouver d'autres applications, notamment un dôme, par exemple destiné à flotter à la surface d'une mer ou d'un océan, ou encore un chapiteau ou une tente.

D'une manière générale, la structure photovoltaïque comprend deux parois définissant entre elles un volume intérieur : une première paroi au moins partiellement transparente au rayonnement solaire et comprenant une face extérieure destinée à être exposée au rayonnement solaire, et une deuxième paroi comprenant une face intérieure en regard de la face intérieure de la première paroi, ladite face intérieure de la deuxième paroi étant au moins partiellement réfléchissante vis-à-vis du rayonnement solaire.

Des modules photovoltaïques comprenant chacun une pluralité de cellules photovoltaïques bifaciales sont agencés sur la face extérieure de la première paroi.

Lorsque la structure est exposée au rayonnement solaire, le rayonnement incident est, pour une part, transmis directement aux cellules bifaciales au travers de la face extérieure desdites cellules, qui est exposée audit rayonnement, et, pour une autre part, transmis à travers la première paroi, plus particulièrement par les éventuels intervalles entre les modules ainsi que par les intervalles entre les cellules photovoltaïques, et pénètre dans le volume intérieur.

Ce rayonnement transmis est réfléchi par la face réfléchissante de la deuxième paroi et transmis aux cellules bifaciales au travers de leur face intérieure en vis-à-vis de la première paroi.

Sur la figure 1, la structure 1 comprend une première paroi 10 qui, dans ce mode de réalisation particulier, forme l'extrados du ballon dirigeable, et une deuxième paroi 14 qui forme l'intrados. Une cabine de pilotage 3 est agencée sous l'intrados.

Les deux parois 10, 14 sont maintenues entre elles par une ossature rigide 13 et forment ainsi une enveloppe fermée et étanche délimitant un volume intérieur 12 contenant un gaz porteur consistant en un gaz léger comprimé pour maintenir la courbure des deux parois requise pour la portance de la structure.

La première paroi 10 est en un matériau léger et au moins partiellement transparent au rayonnement solaire.

Il existe différents matériaux qui conviennent à cet usage : on peut citer en particulier les polyuréthanes, le polytéréphtalate d'éthylène (PET), commercialisé notamment sous la marque Mylar™, ainsi que des textiles techniques commercialisés sous la marque Rivertex™.

La paroi 10 comprend une face extérieure 100 destinée à être exposée au rayonnement solaire, et une face intérieure 101 qui est dirigée vers le volume intérieur 12.

L'épaisseur de la paroi 10 est typiquement comprise entre 0,2 et 1 mm.

De manière avantageuse, la paroi 14 est dans le même matériau que la paroi 10.

A l'intérieur de l'enveloppe formée par les parois 10, 14 est agencée une paroi 11 présentant une face intérieure 110 au moins partiellement réfléchissante située en regard de la face intérieure 101 de la paroi 10.

La paroi 11 est avantageusement maintenue par l'ossature 13.

La paroi 11 peut être formée d'une toile dont la face intérieure 110 est revêtue d'un revêtement réfléchissant.

Selon un mode de réalisation avantageux, la paroi 11 peut être formée par un support métallisé sur sa face 110. Par exemple, la paroi 11 peut être en polymère transparent tel que du PET, du PMMA ou du PC, recouvert d'une couche réfléchissante. La couche réfléchissante est avantageusement une couche métallique, par exemple de l'aluminium ou de l'argent.

Sur sa face 100 qui est destinée à être exposée au rayonnement solaire, la paroi 10 est partiellement revêtue de modules photovoltaïques 2.

Ces modules photovoltaïques ne sont généralement pas jointifs.

Notamment, il existe un intervalle entre deux modules photovoltaïques adjacents, cet intervalle étant en particulier dû au fait que les modules 2 sont généralement rectangulaires tandis que, dans ce mode de réalisation, la paroi 10 possède une forme de révolution.

Une autre motivation de l'existence d'un intervalle entre les modules est que le nombre de modules est limité par la masse de la structure photovoltaïque, ce qui ne permet généralement pas de placer des modules sur toute la surface de la paroi formant l'extrados.

D'autre part, le sommet de la structure n'est généralement pas équipé de modules photovoltaïques. En effet, lorsque les modules sont connectés en série sur un secteur angulaire de la paroi constituant l'extrados, la puissance produite par ledit secteur est limitée par le module photovoltaïque soumis au plus faible éclairement. Ainsi, on évite généralement de placer des modules photovoltaïques jusqu'au sommet de l'extrados pour qu'éviter qu'un défaut d'éclairement dans cette région ne pénalise l'ensemble du secteur.

Dans la structure 1, une partie importante 102 de la surface de la paroi 10 n'est donc pas masquée par les modules photovoltaïques et permet au rayonnement incident de traverser ladite paroi.

Cette partie significative du rayonnement transmis dans le volume intérieur 12 est récupérée au moins en partie au moyen de la face réfléchissante 110 de la paroi 11, et dirigé vers les cellules bifaciales et notamment vers les faces arrières des cellules bifaciales.

A cet égard, le fait que la paroi partiellement réfléchissante soit agencée dans l'enveloppe et ne constitue pas une partie de cette enveloppe (l'intrados par exemple) permet de découpler les contraintes structurelles (par exemple, la nécessité d'une courbure particulière pour assurer la portance de la structure et/ou le fait que l'enveloppe est généralement soumise à des contraintes mécaniques importantes) et les contraintes optiques (par exemple, la possibilité est ainsi offerte d'ajuster le profil de la face au moins partiellement réfléchissante pour optimiser le phénomène de réflexion).

Ainsi, la paroi au moins partiellement réfléchissante subit des contraintes mécaniques moins importantes que l'enveloppe elle-même, ce qui permet d'utiliser d'autres matériaux que ceux de l'enveloppe ; d'autre part, la forme et la géométrie de ladite paroi peuvent être définies indépendamment des considérations aérodynamiques régissant la forme de l'enveloppe.

La figure 2 est une vue de détail de la paroi 10 de la structure 1 illustrée à la figure 1.

Sur cette vue, un module 2 a été représenté en coupe.

Le module 2 comprend typiquement une pluralité de cellules photovoltaïques bifaciales 20 agencée sur un support 21, l'ensemble des cellules et du support étant encapsulé dans un matériau d'encapsulation au moins partiellement transparent au rayonnement solaire.

Le support 21 est par exemple en polymère transparent au rayonnement solaire, tel que le PMMA, le PC, le PET ou le FEP (Perfluoroéthylène-propylène). Selon les applications, le support 21 peut également être en verre mince, tel qu'un verre ayant une épaisseur inférieure ou égale à 0,8mm et présentant une certaine souplesse.

Chaque cellule bifaciale 20 comprend une face extérieure 200 destinée à être exposée au rayonnement solaire incident et une face intérieure 201 en regard de la face extérieure 100 de la paroi 10. Les deux faces 200 et 201 sont photoactives.

Une partie l1 du rayonnement incident provenant du soleil S est transmise au travers de la face extérieure 200 de chaque cellule.

Par ailleurs, l'intervalle entre les modules et, avantageusement, entre les cellules d'un même module, expose au rayonnement solaire des régions 102 de la paroi 10 qui transmettent une partie T2 dudit rayonnement vers le volume intérieur 12.

Ce rayonnement transmis T2 traverse le volume intérieur 12 vers la paroi 11 et se réfléchit sur la face réfléchissante 110 de ladite paroi.

Une partie R3 de ce rayonnement réfléchi traverse le volume intérieur 12 et est transmise au travers de la paroi partiellement transparente 10, puis au travers de la face intérieure 201 des cellules bifaciales 20 qui sont agencées sur celle-ci.

Ainsi, la paroi 11 permet de récupérer une partie significative du rayonnement qui pénètre dans le volume intérieur 12 et d'augmenter par conséquent la puissance électrique produite par la structure.

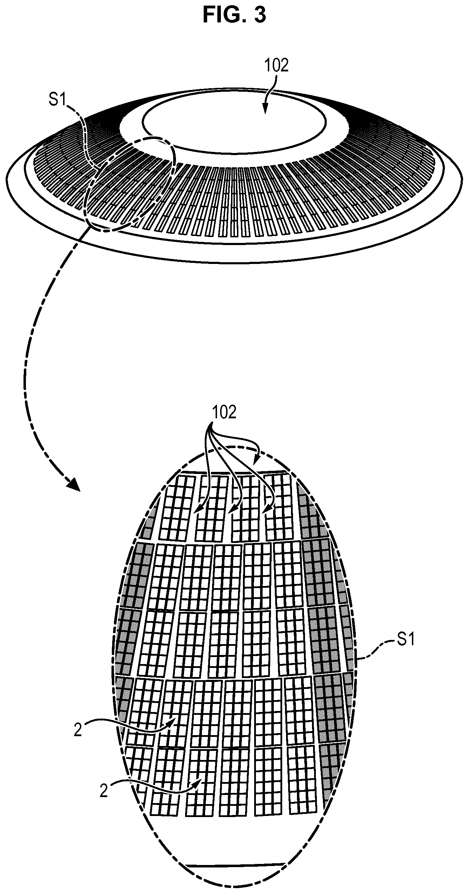

La figure 3 est une vue en perspective de l'extrados de la structure de la figure 1.

Les modules photovoltaïques 2 sont agencés sur la paroi 10, qui est ici en forme de dôme de sorte à former une couronne qui s'étend sur une certaine hauteur, la partie inférieure reliée à l'intrados et le sommet de l'extrados ne supportant pas de modules photovoltaïques. D'autres formes avec un axe ou un plan de symétrie vertical sont également possibles, comme des formes pyramidales par exemple, ainsi que des formes elliptiques présentant un axe de symétrie horizontal.

Les modules sont de préférence agencés de manière réversible à la première paroi, ce qui permet leur remplacement. De manière particulièrement avantageuse, tous les modules 2 sont identiques, ce qui simplifie la maintenance et la gestion des pièces de rechange.

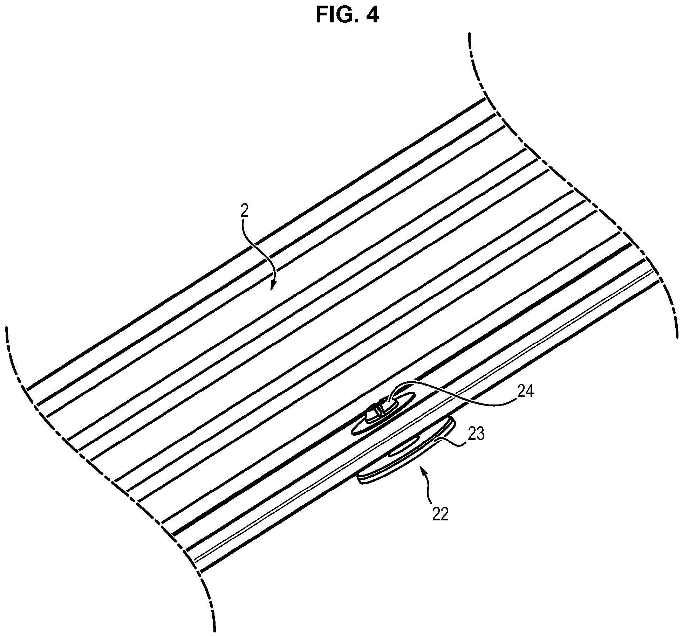

La figure 4 illustre un exemple d'un élément de fixation 22 d'un module 2 sur la première paroi (qui n'est pas représentée).

Ledit élément de fixation 22 comprend une base 23 destinée à être fixée sur la première paroi et un téton s'étendant à partir de la base 23 au travers d'un passage ménagé dans le module 2.

De préférence, les modules 2 présentent une forme rectangulaire.

Le nombre et les dimensions des modules photovoltaïques sont avantageusement choisis en fonction des dimensions de la structure 1 et de la masse qu'elle peut porter.

Il existe donc un intervalle entre deux modules adjacents, ainsi qu'au sommet de l'extrados, qui laisse exposée une portion 102 de la surface de la couche 10 sous-jacente.

La circonférence de la couronne est divisée en une pluralité de secteurs angulaires : dans l'exemple illustré ici, un secteur s1 comprend 26 modules.

Les modules appartenant à un même secteur sont connectés électriquement en série.

Les secteurs sont reliés électriquement en parallèle à un convertisseur de courant qui est lui-même relié à au moins une batterie électrique constituant la source d'énergie de la structure 1.

Cet agencement de la structure 1 permet donc de récupérer une partie significative du rayonnement solaire et donc d'accroître le rendement unitaire de chaque cellule photovoltaïque, à masse constante.

L'invention met donc à profit les zones 102 de la paroi 10 qui ne sont pas masquées par des modules photovoltaïques pour augmenter le rendement de conversion photovoltaïque de chaque module sans que la masse embarquée sur la structure ne soit augmentée.

De préférence, la structure présente au moins un axe ou un plan de symétrie. Cette symétrie permet en effet de compenser des inhomogénéités d'éclairement de la structure et d'homogénéiser la production photovoltaïque d'un secteur angulaire entre deux secteurs angulaires opposés.

Les modules sont avantageusement agencés selon au moins quatre secteurs angulaires, de sorte à permettre d'homogénéiser la production photovoltaïque d'une paire de secteurs angulaires diamétralement opposés. Le nombre de secteurs angulaires sera en particulier adapté selon la forme particulière de la structure et le type d'application choisi.

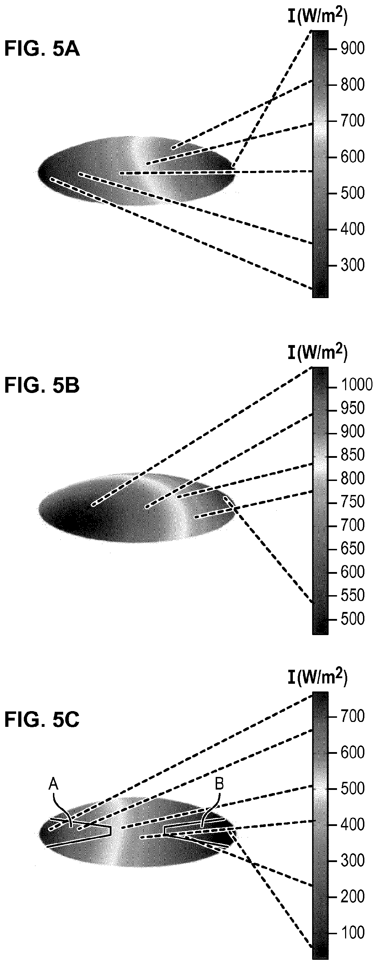

Les figures 5A à 5C illustrent la répartition de l'irradiance du rayonnement solaire sur la surface de la première paroi d'une structure similaire à celle des figures 1 à 3 à trois instants d'une journée, à savoir respectivement 8h30, 14h00 et 17h30.

On observe clairement qu'en fonction du moment de la journée, l'éclairement d'un secteur donné de la structure - et par conséquent la puissance produite - varie notablement.

Par exemple, dans le cas de la figure 5C, le secteur angulaire A qui se trouve le plus éclairé permet de générer une puissance électrique photovoltaïque très supérieure à celle du secteur angulaire B qui lui est diamétralement opposé. Des simulations numériques montrent que l'écart entre les puissances électriques produites par deux secteurs peut varier de quelques pourcents dans le cas le plus favorable (cas où les deux secteurs sont respectivement orientés au nord et au sud) et atteindre un facteur 5 dans le cas le plus défavorable (cas où les deux secteurs sont respectivement orientés à l'est et à l'ouest).

Dans ces cas défavorables, le fait de permettre à une partie du rayonnement auquel est exposé un secteur soumis à un fort éclairement de rejoindre, par réflexion sur la face interne partiellement réfléchissante 110, un secteur soumis à un faible éclairement, permet potentiellement à ce dernier de produire une puissance électrique presque équivalente à celle du premier, même en prenant en compte les pertes par transmission de la paroi 10, les pertes dans la réflexion des rayons et les pertes dues aux ombrages induits par les modules du premier secteur. On estime que l'écart de production électrique entre deux secteurs diamétralement opposés peut alors être réduit au moins de moitié.

La structure pourra naturellement présenter une autre répartition des modules que celle illustrée sur la figure 3 sans pour autant sortir de la portée de la présente invention.

Dans le mode de réalisation de la figure 1, la paroi 11 est plane. L'ossature 13 comprend donc des moyens pour exercer une tension sur la paroi 11 et la maintenir plane.

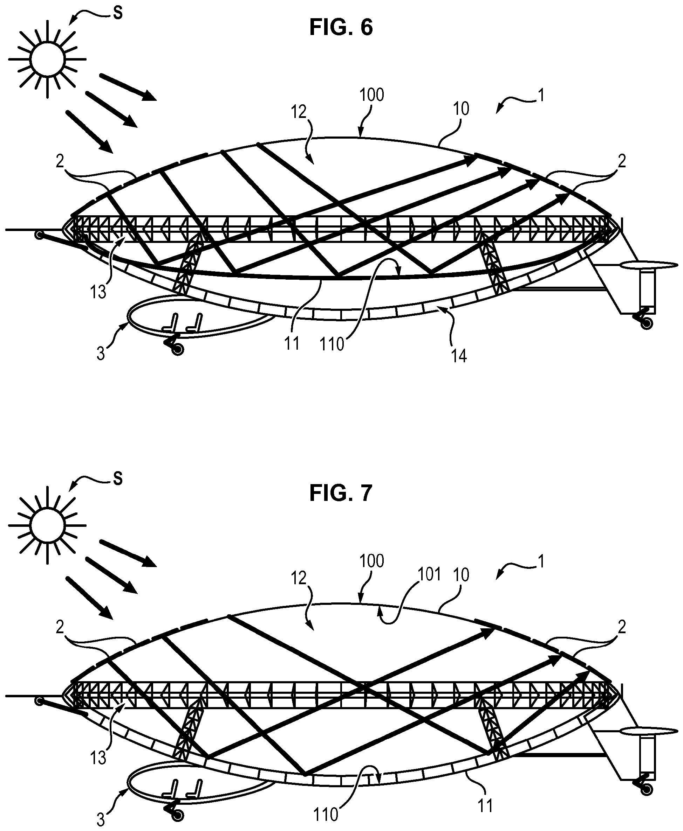

La figure 6 illustre une variante du mode de réalisation de la figure 1, dans lequel la paroi 11 présente une courbure concave optimisée pour conduire le rayonnement solaire transmis au travers d'un secteur de la structure vers le secteur opposé et ainsi homogénéiser la production de cette paire de secteurs.

Des simulations optiques permettent de définir la courbure optimale de la paroi 11 en fonction du positionnement des modules sur la paroi 10, et notamment selon leur organisation en secteurs, en tenant compte des besoins d'homogénéisation du rayonnement en face arrière et des éventuels besoins de focalisation.

La paroi 11 peut présenter une forme plane ou courbe constante au cours du temps.

De manière alternative, la structure peut comprendre un dispositif d'actionnement de la paroi 11 en vue d'ajuster la courbure de ladite paroi en fonction de la position de la structure par rapport au soleil afin de pouvoir optimiser la performance électrique instantanément.

La figure 7 illustre une structure photovoltaïque qui, comme celles des figures 1 et 6, forme un ballon dirigeable. Dans cette structure, la paroi 11 qui présente une face au moins partiellement réfléchissante forme l'intrados, c'est-à-dire qu'elle fait partie de l'enveloppe elle-même. La face au moins partiellement réfléchissante 110 est agencée en regard de la face intérieure 101 de la première paroi 10. Les deux parois 10, 11 sont maintenues entre elles par l'ossature rigide 13 et forment ainsi une enveloppe fermée et étanche délimitant un volume intérieur 12 contenant un gaz porteur consistant en un gaz léger comprimé pour maintenir la courbure des deux parois requise pour la portance de la structure. La paroi 11 est en un matériau léger, qui peut être identique ou différent de celui de la paroi 10, et recouvert d'une couche réfléchissante sur la face 110.

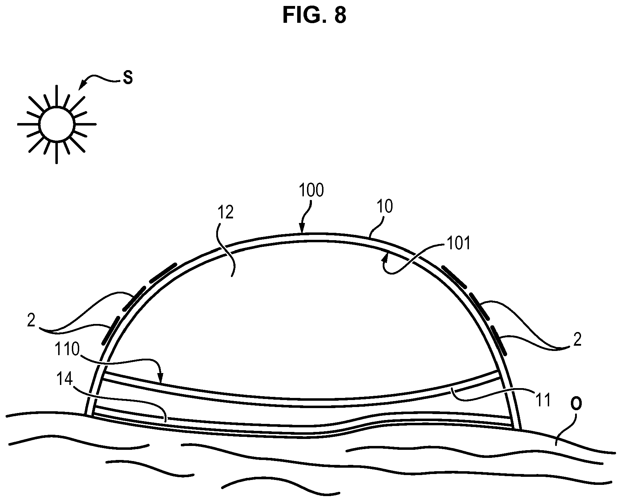

La figure 8 illustre un autre type de structure conçue conformément à l'invention. Il s'agit dans ce cas d'une structure destinée à flotter sur un océan O.

Une telle structure comprend une enveloppe formée d'une première paroi 10 au moins partiellement transparente, formant un dôme et une autre paroi 13 destinée à être posée à la surface de l'océan.

La paroi 11 comprenant une face au moins partiellement réfléchissante est agencée à l'intérieur de cette enveloppe.

La paroi 10 porte une pluralité de modules photovoltaïques 2, de préférence agencés en secteurs.

Pour cette application, les matériaux doivent être adaptés aux contraintes de l'environnement maritime, notamment l'humidité, la salinité de l'eau, la houle et le vent.

L'invention s'applique également à des structures légères (telles que des chapiteaux démontables ou des structures gonflables) équipées de panneaux photovoltaïques et destinées à différents types d'événements (sportifs ou autres).

## Revendications

1. Structure photovoltaïque (1) comprenant une première paroi (10) présentant une forme convexe de révolution et une seconde paroi (11) définissant entre elles un volume intérieur (12),
la première paroi (10) étant au moins partiellement transparente au rayonnement solaire et comprenant une face extérieure (100) destinée à être exposée au rayonnement solaire et une face intérieure (101),
la deuxième paroi (11) comprenant une face intérieure (110) en regard de la face intérieure (101) de la première paroi, ladite face intérieure (110) de la deuxième paroi étant au moins partiellement réfléchissante vis-à-vis du rayonnement solaire, la première paroi formant une partie d'une enveloppe fermée et la deuxième paroi étant agencée à l'intérieur de ladite enveloppe,
ladite structure étant **caractérisée en ce qu'**elle comprend une pluralité de modules photovoltaïques (2) comprenant chacun une pluralité de cellules photovoltaïques bifaciales (20), lesdits modules (2) étant répartis sur la face extérieure (100) de la première paroi selon une pluralité de secteurs angulaires (s1), les modules photovoltaïques d'un même secteur angulaire étant reliés en série, chaque cellule bifaciale (20) comprenant une face extérieure (200) destinée à être exposée au rayonnement solaire incident et une face intérieure (201) en regard de la face extérieure (100) de la première paroi,
de sorte que lorsque la structure (1) est exposée au rayonnement solaire, une première portion (l1) du rayonnement incident est transmise vers la face extérieure (200) desdites cellules photovoltaïques bifaciales (20), une deuxième portion (T2) dudit rayonnement incident est transmise à travers une partie (102) de la première paroi (10) et se réfléchit au moins partiellement sur la face intérieure (110) de la deuxième paroi, ladite portion réfléchie (R3) étant transmise à travers la première paroi (10) vers la face intérieure (201) des cellules photovoltaïques bifaciales (20).

2. Structure selon la revendication 1, dans laquelle les modules photovoltaïques (2) sont agencés de manière non jointive sur la première paroi (10), une portion du rayonnement incident étant transmise au travers d'une partie de la première paroi située entre deux modules photovoltaïques non jointifs.

3. Structure selon l'une des revendications 1 ou 2, dans laquelle la deuxième paroi (11) est plane.

4. Structure selon l'une des revendications 1 ou 2, dans laquelle la deuxième paroi (11) présente une courbure ajustée en fonction de la courbure de la première paroi (10) et de la répartition des modules photovoltaïques (2) sur la première paroi pour optimiser la réflexion du rayonnement incident transmis au travers d'une région de la première paroi vers la face intérieure (201) des cellules desdits modules situés dans la région opposée de ladite première paroi.

5. Structure selon l'une des revendications 1 à 4, comprenant un dispositif d'actionnement de la deuxième paroi (11), adapté pour ajuster la courbure de ladite deuxième paroi en fonction de la position de la structure (1) par rapport au soleil.

6. Structure selon l'une des revendications 1 à 5, présentant au moins un plan ou un axe de symétrie.

7. Structure selon l'une des revendications 1 à 6, dans laquelle une portion sommitale de la première paroi (10) est dépourvue de modules photovoltaïques.

8. Structure selon l'une des revendications 1 à 7, dans laquelle tous les modules photovoltaïques (2) agencés sur la première paroi sont identiques.

9. Structure selon l'une des revendications 1 à 8, dans laquelle les modules photovoltaïques (2) sont agencés de manière réversible sur la première paroi (10).

10. Structure selon l'une des revendications 1 à 9, dans laquelle le matériau de la première paroi (10) comprend un tissu de fibres de verre.

11. Structure selon l'une des revendications 1 à 10, dans laquelle la deuxième paroi (11) est en polytéréphtalate d'éthylène (PET) métallisé sur sa face intérieure (110).

12. Ballon dirigeable lenticulaire comprenant une structure selon l'une des revendications 1 à 11, l'enveloppe de ladite structure étant remplie d'un gaz porteur.

13. Dôme destiné en particulier à flotter à la surface d'une mer ou d'un océan, comprenant une structure selon l'une des revendications 1 à 11.

## Patentansprüche

1. Photovoltaische Struktur (1), umfassend eine erste Wand (10), die eine konvexe Revolutionsform und eine zweite Wand (11), die untereinander ein Innenvolumen (12) definieren, aufweist
wobei die erste Wand (10) wenigstens teilweise für Sonnenbestrahlung transparent ist und eine Außenseite (100), die dazu bestimmt ist, der Sonnenbestrahlung ausgesetzt zu sein, und eine Innenseite (101) umfasst,
wobei die zweite Wand (11) eine Innenseite (110) gegenüber der Innenseite (101) der ersten Wand umfasst, wobei die genannte Innenseite (110) der zweiten Wand wenigstens teilweise gegenüber der Sonnenbestrahlung reflektierend ist, wobei die erste Wand einen Teil einer geschlossenen Hülle formt und die zweite Wand im Innern der genannten Hülle angeordnet ist,
wobei die genannte Struktur **dadurch gekennzeichnet ist, dass** sie eine Vielzahl von photovoltaischen Modulen (2) umfasst, die jeweils eine Vielzahl von zweiseitigen photovoltaischen Zellen (20) umfasst, wobei die genannten Module (2) auf der Außenseite (100) der ersten Wand gemäß einer Vielzahl von winkelförmigen Sektoren (s1) verteilt sind, wobei die photovoltaischen Module eines und desselben winkelförmigen Sektors in Serie verbunden sind, wobei jede zweiseitige Zelle (20) eine Außenseite (200), die dazu bestimmt ist, der einfallenden Sonnenbestrahlung ausgesetzt zu sein, und eine Innenseite (201) gegenüber der Außenseite (100) der ersten Wand umfasst,
derart, dass, wenn die Struktur (1) der Sonnenbestrahlung ausgesetzt ist, ein erster Abschnitt (I1) der einfallenden Bestrahlung auf die Außenseite (200) der genannten zweiseitigen photovoltaischen Zellen (20) übertragen ist, ein zweiter Abschnitt (T2) der genannten einfallenden Strahlung durch einen Teil (102) der ersten Wand (10) übertragen ist und wenigstens teilweise auf der Innenseite (110) der zweiten Wand reflektiert ist, wobei der reflektierte Abschnitt (R3) durch die erste Wand (10) zu der Innenseite (201) der zweiseitigen photovoltaischen Zellen übertragen ist.

2. Struktur gemäß Anspruch 1, bei der die photovoltaischen Module (2) aneinander nicht anstoßend auf der ersten Wand (10) angeordnet sind, wobei ein Abschnitt der einfallenden Bestrahlung durch einen Teil der ersten Wand übertragen ist, der zwischen zwei nicht aneinander anliegenden photovoltaischen Modulen übertragen ist.

3. Struktur gemäß einem der Ansprüche 1 oder 2, bei der die zweite Wand (11) eben ist.

4. Struktur gemäß einem der Ansprüche 1 oder 2, bei der die zweite Wand (11) eine Krümmung aufweist, die in Abhängigkeit von der Krümmung der ersten Wand (10) und der Verteilung der photovoltaischen Module (2) auf der ersten Wand angepasst ist, um das Reflektieren der einfallenden Strahlung zu optimieren, die durch eine Region der ersten Wand zu der Innenseite (210) der Zellen der genannten Module übertragen ist, die in der entgegengesetzten Region der genannten ersten Wand angeordnet sind.

5. Struktur gemäß einem der Ansprüche 1 bis 4, umfassend eine Betätigungsvorrichtung der zweiten Wand (11), die geeignet ist, um die Krümmung der genannten zweiten Wand in Abhängigkeit von der Position der Struktur (1) im Verhältnis zur Sonne anzupassen.

6. Struktur gemäß einem der Ansprüche 1 bis 5, die wenigstens eine Symmetrieebene oder eine Symmetrieachse aufweist.

7. Struktur gemäß einem der Ansprüche 1 bis 6, bei der ein Scheitelabschnitt der ersten Wand (10) keine photovoltaischen Module aufweist.

8. Struktur gemäß einem der Ansprüche 1 bis 7, bei der alle photovoltaischen Module (2), die auf der ersten Wand angeordnet sind, identisch sind.

9. Struktur gemäß einem der Ansprüche 1 bis 8, bei der die photovoltaischen Module (2) reversibel auf der ersten Wand (10) angeordnet sind.

10. Struktur gemäß einem der Ansprüche 1 bis 9, bei der das Material der ersten Wand (10) ein Glasfasergewebe umfasst.

11. Struktur gemäß einem der Ansprüche 1 bis 10, bei der die zweite Wand (11) aus metallisiertem Polyethylenterephthalat (PET) auf der Innenseite (110) ist.

12. Linsenförmiges lenkbares Luftschiff, umfassend eine Struktur gemäß einem der Ansprüche 1 bis 11, wobei die Hülle der genannten Struktur mit einem Trägergas gefüllt ist.

13. Kuppel, die insbesondere zum Schweben auf der Oberfläche eines Meers oder eines Ozeans bestimmt ist, umfassend eine Struktur gemäß einem der Ansprüche 1 bis 11.

## Claims

1. A photovoltaic structure (1) comprising a first wall (10) having a convex rotational shape and a second wall (11) defining an inner space (12) therebetween,
the first wall (10) being at least partly transparent to solar radiation and comprising an outer face (100) intended to be exposed to solar radiation and an inner face (101),
the second wall (11) comprising an inner face (110) facing the inner face (101) of the first wall, said inner face (110) of the second wall being at least partly reflective with regard to solar radiation, the first wall forming a part of a closed envelope and the second wall being arranged inside said envelope,
said structure being **characterised in that** it comprises a plurality of photovoltaic modules (2) each comprising a plurality of bifacial photovoltaic cells (20), said modules (2) being arranged on the outer face (100) of the first wall in a plurality of angular sectors (s1), the photovoltaic modules of one and the same angular sector being linked in series, each bifacial cell (20) comprising an outer face (200) intended to be exposed to incident solar radiation and an inner face (201) facing the outer face (100) of the first wall,
so that when the structure (1) is exposed to solar radiation, a first portion (11) of the incident radiation is transmitted toward the outer face (200) of said bifacial photovoltaic cells (20), a second portion (T2) of said incident radiation is transmitted through a part (102) of the first wall (10) and at least partly reflects off the inner face (110) of the second wall, said reflected portion (R3) being transmitted through the first wall (10) toward the inner face (201) of the bifacial photovoltaic cells (20).

2. The structure according to claim 1, wherein the photovoltaic modules (2) are arranged in a non-contiguous way on the first wall (10), a portion of the incident radiation being transmitted through a part of the first wall located between two non-contiguous photovoltaic modules.

3. The structure according to one of claims 1 or 2, wherein the second wall (11) is planar.

4. The structure according to one of claims 1 or 2, wherein the second wall (11) has a curvature adjusted as a function of the curvature of the first wall (10) and of the distribution of the photovoltaic modules (2) on the first wall to optimise the reflection of the incident radiation transmitted through a region of the first wall toward the inner face (201) of the cells of said modules located in the opposite region of said first wall.

5. The structure according to one of claims 1 to 4, comprising a device for actuating the second wall (11), adapted to adjust the curvature of said second wall as a function of the position of the structure (1) with respect to the sun.

6. The structure according to one of claims 1 to 5, having at least one plane or one axis of symmetry.

7. The structure according to one of claim 1 to 6, wherein a summit portion of the first wall (10) is without photovoltaic modules.

8. The structure according to one of claims 1 to 7, wherein all the photovoltaic modules (2) arranged on the first wall are identical.

9. The structure according to one of claims 1 to 8, wherein the photovoltaic modules (2) are arranged reversibly on the first wall (10).

10. The structure according to one of claims 1 to 9, wherein the material of the first wall (10) comprises a glass fiber fabric.

11. The structure according to one of claims 1 to 10, wherein the second wall (11) is made of polyethylene terephthalate (PET) metallized on its inner face (110).

12. A lenticular airship comprising a structure according to one of claims 1 to 11, the envelope of said structure being filled with a carrier gas.

13. A dome specifically intended to float on the surface of a sea or an ocean, comprising a structure according to one of claims 1 to 11.
